# EUROPEAN PATENT APPLICATION

(11) **EP 2 866 161 A1**
(43) Date of publication of application: **29.04.2015**
(21) Application number: 14188692.9
(22) Date of filing: 13.10.2014
(51) Int. Cl.: G06F 17/50

(54) **System and method for visualization and optimization of system of systems**

(30) Priority: 28.10.2013 US 201314064693
(71) Applicant: The Boeing Company, Chicago, IL 60606-2016 (US)
(72) Inventor: Milstead, James M., Huntsville, AL Alabama 35824 (US); Cramer, Evin J., Seattle, WA Washington 98124 (US); Kamsickas, Gary, Huntsville, AL Alabama 35824 (US); Sellers, Paul S., St. Louis, MO Missouri 63166 (US)
(74) Representative: Carpmaels & Ransford LLP

(57) **Abstract**

A system for visualizing and optimizing the operation of a system of systems. A Design of Experiments is conducted for a particular system of systems architecture using a simulation engine based upon a predefined set of inputs. The results are stored in a database as real data. Surface Response Models are built based upon the results and simulation data is generated and stored based on the Surface Response Models for data not present in the results. The results of the Design of Experiments are filtered to identify key variables. Values and rankings are selected for the key variables. An interim output is generated and displayed based on the selected values and rankings. The interim output is determined based on the real and simulation data. The results are verified by performing a simulation based on the selected values and comparing the simulation output with the interim output.

## Description

### FIELD

This invention relates generally to the visualization and optimization of system of systems architectures.

### BACKGROUND

A System-of-Systems (SoS) is a collection of dedicated systems which pool resources and capabilities to create a new, more complex system which offers more functionality and performance than simply the sum of the constituent systems.

Developing optimal architectures for large System-of-Systems requires performing trades among many different disciplines. For example, in the missile defense domain the selection of sensors and interceptors, where they are positioned, and their properties such as burn-out velocity, detection range, field of view, or communications latency all have an impact on the overall performance of the system - i.e., how well it defends against incoming threats. The sheer volume of different architectural possibilities makes timely visualization of the design space a significant challenge.

System-of Systems (SoS) Multidisciplinary Design, Analysis, and Optimization (MDAO) is used to determine which architectural components (systems) have the most impact on the overall performance of the overall system. A system-level model or simulation is constructed and a design of experiment (DoE) performed to vary architectural components or component properties to determine how the overall system performs under a multitude of different configurations. Phoenix Integration's ModelCenter is a standard tool used to perform DoEs. A typical ModelCenter workflow for Systems of Systems analysis problems involves an analyst executing a DoE, filtering out a set of "interesting" results from among the millions of alternatives, and presenting the filtered responses to a customer for review. Real-time manipulation of data and visualization of results directly from ModelCenter are often impractical for models requiring a long execution cycles. As a result, the filtered responses provide a static presentation without any ability to respond in real-time to "what-if" scenarios or questions not considered in the original DoE.

### SUMMARY

The present invention provides a system and method for visualizing and optimizing the operation of a system of systems. A Design of Experiments is conducted for a particular system of systems architecture using a simulation engine running on a processor and based upon a predefined set of inputs. The results of the Design of Experiments are stored in a database in a memory as real data. Surface Response Models are built based upon the results of the Design of Experiments and stored the Surface Response Models in memory. Simulation data is generated based on the Surface Response Models for data not present in the results of the Design of Experiments stored in the database and the simulation data is stored in the database. The results of the Design of Experiments are filtered to identify key variables. A graphical user interface on a user display is used to select a value for at least one of the key variables. An interim output is generated and displayed on the user display that is based on the selected values for the at least one of the key variables. The interim output is determined based on the real data and the simulation data stored in the database.

In addition, the results may be verified by performing a simulation using the simulation engine running on a processor based on the selected values and comparing the simulation output with the interim output.

Further, selected key variables may be aggregated to provide at least one aggregate function that controls values for each of the selected key variables. When aggregate functions are provided, the graphical user interface on the user display is used to select a value for the at least one of the aggregate functions.

Still further, a ranking may be selected for the at least one of the key variables. In this case, the interim output is generated based on the selected values and the selected rankings. In a further embodiment, a value is selected for all of the key variables and/or a ranking is selected for all of the key variables.

### BRIEF DESCRIPTION OF THE DRAWINGS

The following detailed description, given by way of example and not intended to limit the present invention solely thereto, will best be understood in conjunction with the accompanying drawings in which:
FIG. 1A is a block diagram of an optimization system according to a presently preferred embodiment, and FIG. 1B is a block diagram of a computer apparatus for operating the optimization system;
FIGS. 2A, 2B and 2C show a flow chart showing the operation of the optimization system of FIG. 1A;
FIG. 3 is a flow chart showing the filtering operations performed by the optimization system of FIG. 1A;
FIG. 4 is a flow chart showing the visualization operations performed by the optimization system of FIG. 1A;
FIG. 5 is a flow chart showing the optimization operations performed by the optimization system of FIG. 1A;
FIGS. 6A and 6B are screen shots of the graphical user interface used to control and display the output of the optimization system of FIG. 1A; and
FIG. 7 is a close-up of a screen shot of the graphical user interface showing how the location preferences are identified.

### DETAILED DESCRIPTION

In the present disclosure, like reference numbers refer to like elements throughout the drawings, which illustrate various exemplary embodiments of the present invention.

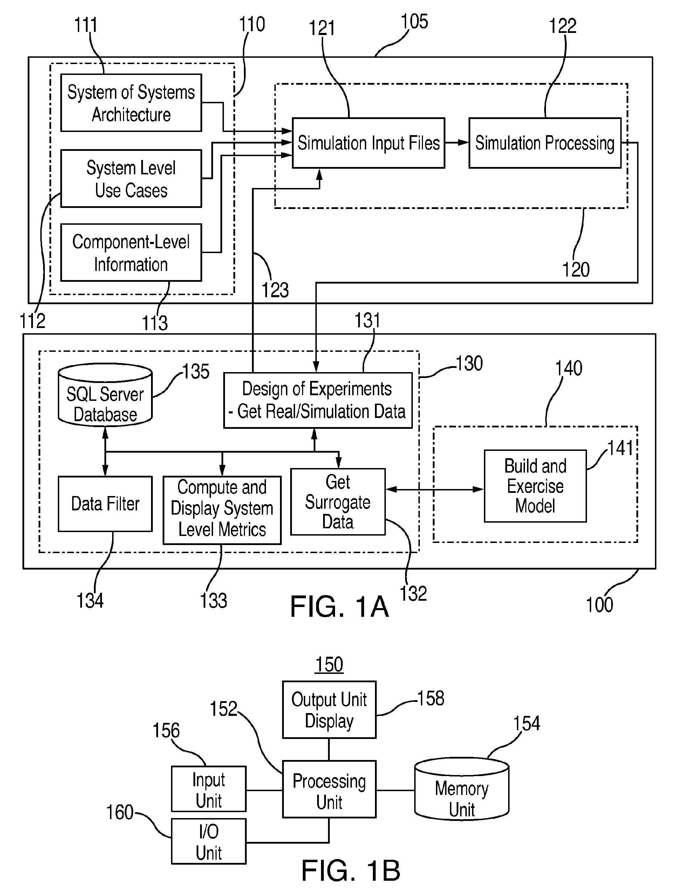

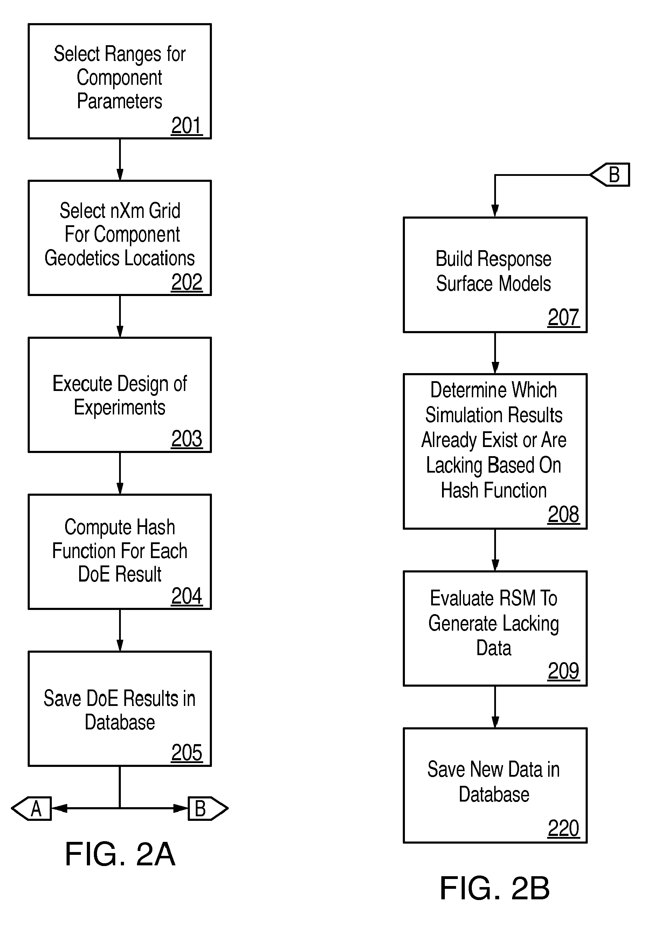

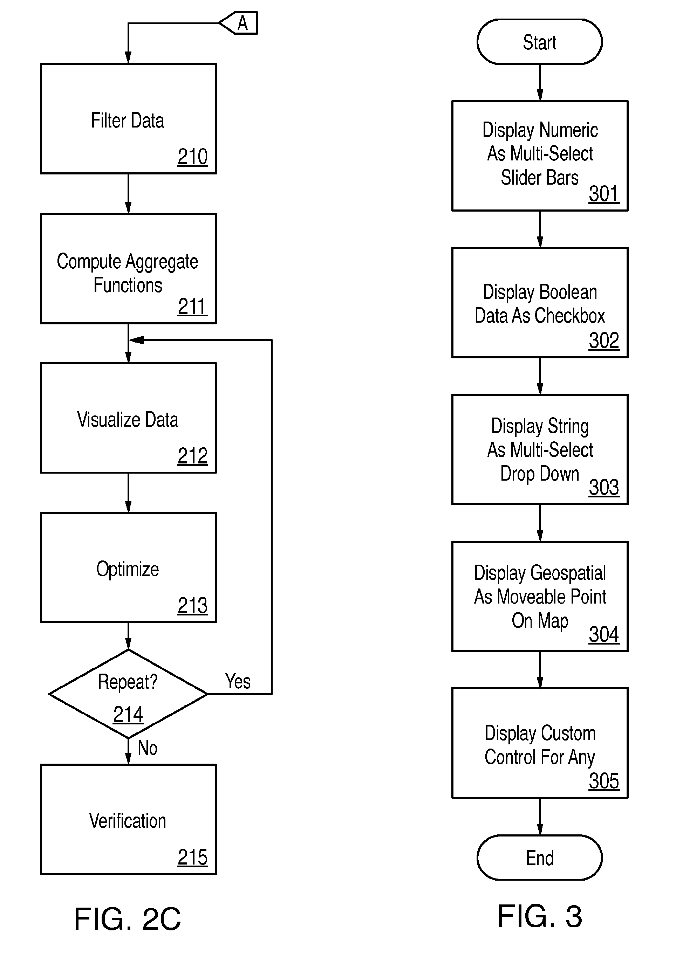

Referring now to the drawings and in particular to FIG. 1A, a block diagram is shown that is useful in understanding the operation of the visualization and optimization system 100 according to a preferred embodiment. In particular, visualization and optimization system 100 receives simulation results from a simulation system 105, which are generated under various system/component configurations set under the control of a design of experiments module 131 (discussed below). The simulation results are stored in a database, for example, an SQL server database 135. As discussed in more detail below with respect to FIG. 2, the visualization and optimization system 100 processes the simulation results and generates Response Surface Models from the simulation results. A Response Surface Model is a computationally efficient mathematical model that approximates a single response quantity (the dependent variable) as function of one or more independent variables. The response quantity is typically generated from experimental data or using computer simulation data. In the preferred embodiment, the Response Surface Models are then used to generate information about the operation of the system of systems at inputs different than that used for the various simulation runs under the design of experiments and are used as a part of the optimization process. Once RSM models are verified for validity against truth models, their use significantly reduces the number of simulations that must be executed under the design of experiments and thus also significantly reduces the associated runtime, and also greatly increases the number of variables which can be considered in the analysis and reduces the cycle time for completing a particular analysis.

The operation of the simulation system 105 may be conventional. Systems information 110 is input into a modeling system 120 to simulate the operation of the system of systems for a controlled set of parameters. The simulation information 110 may include, for example, information 111 about the particular system of systems architecture, information 112 about system level use cases and component-level information 113. The modeling system 120 may be any conventional system for modelling a system of systems, including, for example, ModelCenter from Phoenix Integration. The modeling system 120 may include an input section 121 for receiving the simulation information 110 and a simulation processing section 122. Input section 121 also has a separate input 123 used to receive information from the design of experiments module 131 that is used vary the simulation information 110 as part of a predetermined design of experiments. The simulation input section 121 forwards the simulation input information to the simulation processing section 122 in a step-wise manner for processing (i.e., each step correspond to a defined set of input parameters corresponding to particular and controlled variation to an original component property or architectural component, with the variations under the control of input 123) and output. The output of the simulation processing section 122 consists of a series of sets of simulation results, each set corresponding to a particular set of input parameters.

The visualization and optimization system 100 includes two sub-systems. First, a user-interface system 130 provides a framework for generating output displays and also includes a number of modules 131-135 for generating, filtering, processing and displaying the simulation results. User-interface system 130 includes design of experiments module 131, an SQL server database module 135, a data filter module 134, a system level metrics display module 133 and a surrogate model control module 132. Second, a modeling system 140 is used to build and exercise the response surface models for the current system of systems. Modeling system 140 includes a module 141 for building and exercising response surface models. The operation of each subsystem and the respective modules is explained in conjunction with FIGS. 2A, 2B and 2C.

As one of ordinary skill in the art will readily recognize, the visualization and optimization system can be realized in hardware, software, or a combination of hardware and software. A system according to the preferred embodiment can be realized in a centralized fashion in one computer system, or in a distributed fashion where different elements are spread across several interconnected computer systems. Any kind of computer system or other apparatus adapted for carrying out the methods described herein is suited. A typical combination of hardware and software could be a general purpose computer system with a computer program that, when being loaded and executed, controls the computer system such that it carries out the methods described herein. For example, a general purpose computer 150 is shown in FIG. 1B which includes a processing unit 152 (e.g., computer processor), a memory unit 154 (e.g., hard disk, RAM, ROM) an input interface 156 (e.g., keyboard), an output device 158 (e.g., a user display) and an input/output device 160 (e.g., disk drive, USB interface, etc.).

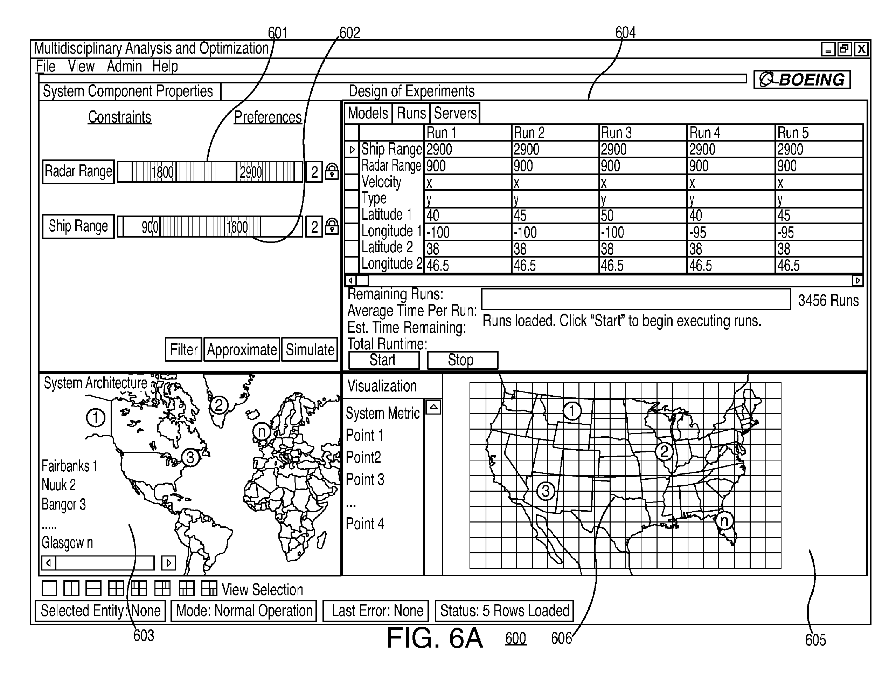

The Design of Experiments module 131 controls, via line 123, the simulation runs performed by simulation processing section 122. In particular and referring to FIG. 2A, the first step in performing the Design of Experiments is preferably to select the ranges for the component parameters (step 201). This requires evaluating and setting ranges on the component-level information 113 shown in FIG. 1A. Next, an n X m grid may be selected (e.g., the grid 606 shown in FIG. 6A) for component geodetics locations (step 202). This information may be based on, for example, information within the system level use cases 112 shown in FIG. 1A. Once the selections are made (from steps 201 and 202), the Design of Experiments is executed at step 203. As discussed above, the Design of Experiments involves performing a series of simulation runs (by simulation processing section 122) in step-wise manner varying the input information. The Design of Experiments module 131 (FIG. 1A) receives the simulation data (the "real" data) and computes a hash function for each result (step 204) and then stores the results and associated hash function in the SQL server database 135 (step 205). Prior to storing the data, the simulation data from modelling system 120 is denormalized into a flat file (e.g., a comma-separated value, or CSV, file) which is used to generate a single database table to hold the data. This de-normalization process is important so that system 100 may be generic and work on any data. The data types of the input data (string, integer, decimal, Boolean) is automatically detected and a database schema (table) is generated. A user may specify which fields are to be used as input filters for driving what-if scenario analysis and indices are built on the database table to allow system 100 to query the data quickly. The data is then input from the flat file into the new database table in database 135.

Referring now to FIG. 2B, once the data is imported into the database, Response Surface Models (RSMs) are generated to represent the data (step 207) under the control of the Get Surrogate Data module 132. In the presently preferred embodiment, module 132 is coupled to modeling system 140 to perform this step. Modeling system 140 is preferably a Boeing-developed tool called Design Explorer, however other tools providing the same functionality may be alternatively used to generate the Response Surface Models. To build the model, the dataset is split into multiple models based on a Cartesian product of all possible values of all the Boolean and string variables. Each combination of Boolean/string variables becomes a model, since no interpolation can be done between Boolean or string values. Next, it is determined which simulation results are lacking (missing) in database 135, based on the previously generated hash functions (step 208). If data is missing, the appropriate RSM is evaluated to generate the missing data (step 209). As discussed below, if a user specifies data that does not already exist in database 135 during the optimization step 213, an associated Response Surface Model is likewise invoked to generate the missing data. Finally, the generated data (called "surrogate data" because it is based on the RSM and not on the original simulation) is automatically imported into database 135, thereby seamlessly merging the surrogate data with the existing simulation (real) data, at step 220.

FIG. 2C shows the steps performed in the actual visualization and optimization of the System of Systems being evaluated (as defined by the parameters 111 shown in FIG. 1A). The first step performed is to filter the data (step 210). Step 210 is performed by the data filter module 134 (FIG. 1A) and involves a number of discrete tasks (as shown in FIG. 3) setting up user controls to facilitate the what-if scenario generation. Numeric inputs (integer, decimal) may be displayed as slider bar controls with a minimum and maximum value which allows a user to specify a range of values of interest (step 301). Boolean values may be displayed as check boxes, which may also enable/disable display of an element on a map (step 302). Strings may be displayed as multi-select drop down controls to allow selection of multiple values (step 303). A map may be displayed to show geospatial elements, which elements may also be moved to different positions on the map by a user (step 304). Finally, interfaces may be provided to build new data filtering controls which can interact with the other "out-of-the-box" controls (step 305).

Once the user has specified filtering options, aggregate functions are computed based on the inputs (step 211). System 100 generates dynamic database queries to perform a "group by" operation on the selected values to yield a set of rows that match the filter (primary results), as well as a subset of rows that match each row in the filtered set but contain fields that were not part of the filter (secondary results). This yields a 1-to-many relationship out of a flat database table. The secondary results can then be used as input to an aggregate function to compute values for each row. As a practical example of how this is used - in missile defense a typical metric is "defended area" which is determined by assessing the performance of the system at various "aim points". A simulation run is performed for each aim point, under a given set of conditions. Those conditions become the filter, and the individual runs at each aim point under those same conditions become the subset (secondary results) of "many" that can be used to compute the aggregate defended area function. The filtering user interface is programmatically generated and then tailorable to insure only relevant database fields are displayed. In this way, the user interface is simplified for non-technical personnel (such as marketing or business development personnel) who are familiar with the system operation and parameters but not the underlying simulation models and database structure.

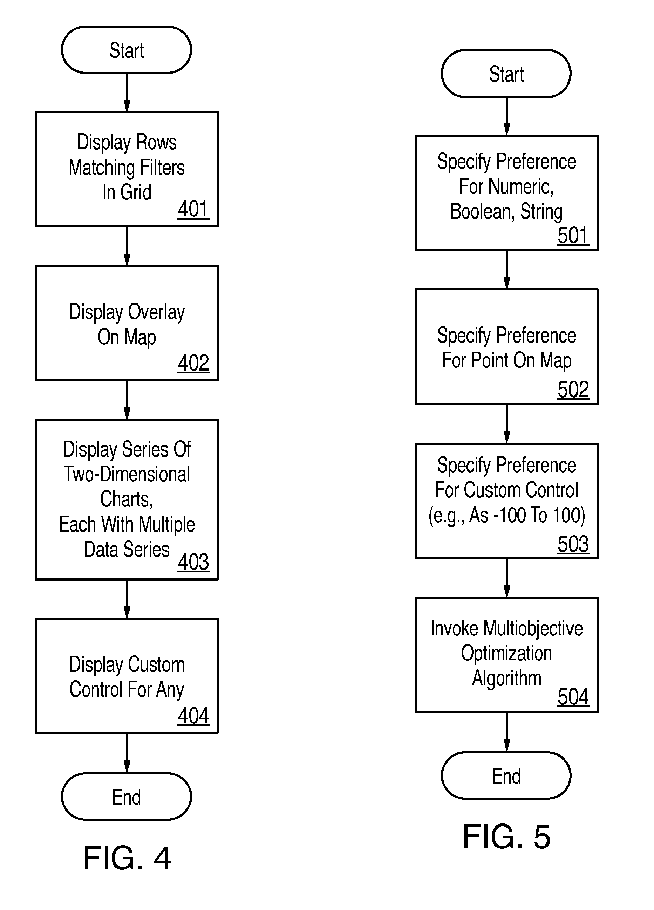

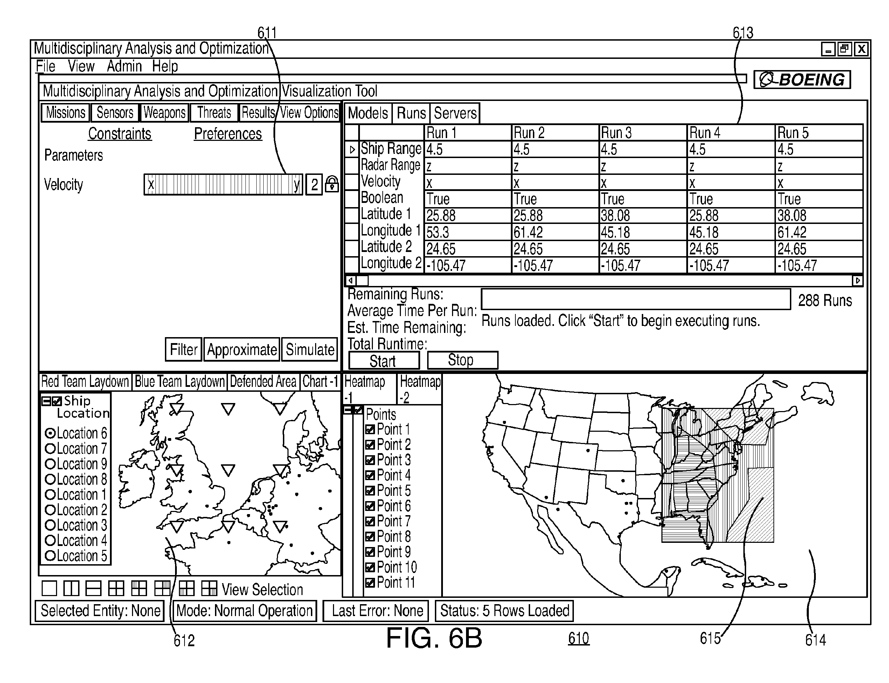

Referring now to FIGS. 2C and 4, a visual view of the data is provided by system 100 (step 212) (see also FIGS. 6A and 6B discussed below). In particular, a two-level grid control is preferably provided to show the rows matching the filters (primary rows), as well as the subset rows for each primary row that also match the filter but do not include the filtered columns themselves (step 401). An overlay may be displayed on the map generated from the filtered primary or secondary rows (step 402). A series of N two-dimensional charts, each with M series of X,Y data is generated which allows visualization of four variables against each other without relying on three-dimensional charts (step 403). Finally, as with filtering, interfaces are provided for building new visualization controls which can operate on the filtered data and computed aggregate functions (step 404).

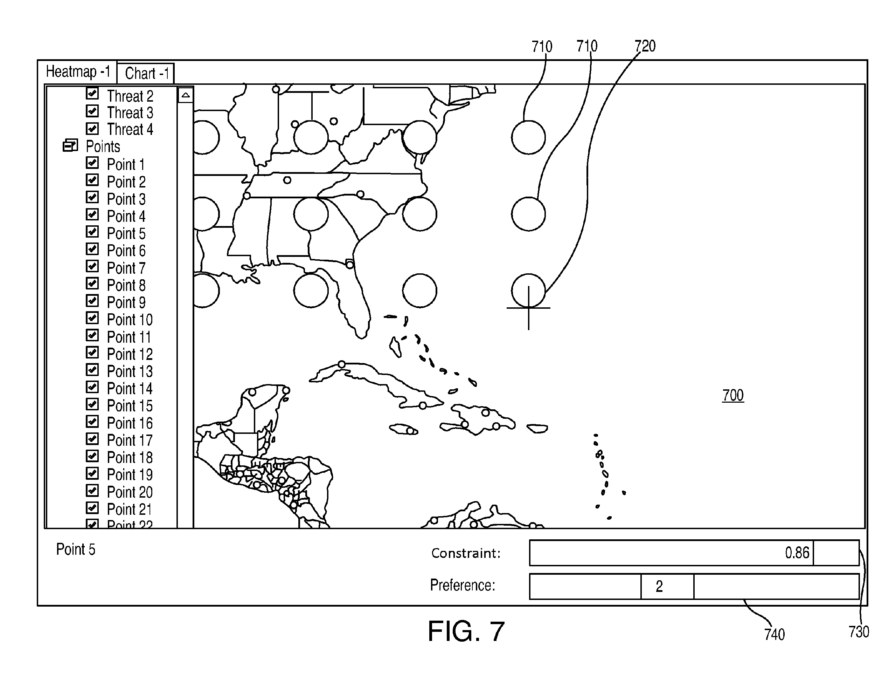

Referring now to FIGS. 2C and 5, in the optimize step 213, a user, by way of user interface controls, specifies preferences by selecting a particular level of importance by, preferably, adjusting a slider between a level of minimization (-100) and maximization (+100) for each (or a selected subset of) the fields for the data in the database (for example, each filter may be available as an adjustable slider here) (step 501). A user is also able to specify preferences for locations via a map (e.g., as shown in FIG. 7, a user may select an area on a map) (step 502). In line with the filter step 304, an interface is provided to implement a custom user control to gather corresponding preference values for any custom user controls (step 503). Thereafter, another response surface model is generated based on the filtered data and user preferences and the model is evaluated to get the optimized results which are displayed using the visualization controls (step 504).

Based on the optimized results, at step 214 in FIG. 2C a user can elect to either repeat the visualization and optimization steps based on modified inputs or to proceed to the verification step 215. verification of the Response Surface Models is performed by performing a full simulation run based on the optimal inputs generated during the optimize step 213 and then comparing that output (based on actual simulation data) with the output generated with the Response Surface Models in step 213. In a presently preferred implementation, modeling system 120 is invoked to run this verification level simulation.

Referring now to FIG. 6A, a graphical user interface 600 is shown for use in controlling a first part of the visualization and optimization system of the preferred embodiment. In particular, graphical user interface 600 includes slide controls 601, 602 and a map 603 for setting a range (or positions) for the component parameters (corresponding to step 201 in FIG. 2A). In addition, graphical user interface 600 also includes a map 605 for setting a grid 606 for component geodetics locations (corresponding to step 202 in FIG. 2A). This is shown in more detail in FIG. 7 by the location of grid markings 710, 720 on a map 700 that set forth certain of the selected portions. In addition, FIG. 7 shows slider controls 730, 740 for setting geodetic constraint/preference information for a selected point 720. Finally, graphical user interface 600 includes a table 604 that shows how the Design of Experiments step 203 (FIG. 2A) will be carried out (in terms of sequential runs).

Referring now to FIG. 6B, a second graphical user interface 610 is shown for use in controlling a second part of the visualization and optimization system of the preferred embodiment. In particular, graphical user interface 610 includes a slider 611 that is used to set the preference level for a particular variable. The preference level corresponds to a weighting or significance provided to such variable, and preferably ranges from -100 to +100. In addition, the second graphical user interface 610 also includes a map 612 which allows a user to move points to new locations as part of the optimization process. Further, the second graphical user interface 610 includes a table 613 showing the data from the Design of Experiments output. Finally, the second graphical user interface 610 includes a heat map 614 providing a visualization of the system level metrics (shown by the different level of shading in FIG. 6B).

The figures include block diagram and flowchart illustrations of methods and systems according to the preferred embodiment. It will be understood that each block in such figures, and combinations of these blocks, can be implemented by computer program instructions. These computer program instructions may be loaded onto a computer or other programmable data processing apparatus to produce a machine, such that the instructions which execute on the computer or other programmable data processing apparatus create means for implementing the functions specified in the block or blocks. These computer program instructions may also be stored in a computer-readable medium or memory that can direct a computer or other programmable data processing apparatus to function in a particular manner, such that the instructions stored in the computer-readable medium or memory produce an article of manufacture including instruction means which implement the function specified in the block or blocks. The computer program instructions may also be loaded onto a computer or other programmable data processing apparatus to cause a series of operational steps to be performed on the computer or other programmable apparatus to produce a computer implemented process such that the instructions which execute on the computer or other programmable apparatus provide steps for implementing the functions specified in the block or blocks.

Those skilled in the art should readily appreciate that programs defining the functions of the present invention can be delivered to a computer in many forms; including, but not limited to: (a) information permanently stored on non-writable storage media (e.g. read only memory devices within a computer such as ROM or CD-ROM disks readable by a computer I/O attachment); (b) information alterably stored on writable storage media (e.g. floppy disks and hard drives); or (c) information conveyed to a computer through communication media for example using wireless, baseband signaling or broadband signaling techniques, including carrier wave signaling techniques, such as over computer or telephone networks via a modem.

Although the present invention has been particularly shown and described with reference to the preferred embodiments and various aspects thereof, it will be appreciated by those of ordinary skill in the art that various changes and modifications may be made without departing from the spirit and scope of the invention. It is intended that the appended claims be interpreted as including the embodiments described herein, the alternatives mentioned above, and all equivalents thereto.

According to an aspect of the present disclosure there is provided a computer-implemented method for visualizing and optimizing the operation of a system of systems, comprising the steps of: conducting a Design of Experiments for a particular system of systems architecture using a simulation engine running on a processor and based upon a predefined set of inputs; storing the results of the Design of Experiments in a database in a memory as real data; partitioning the results of the Design of Experiments into subsets, automating the construction of Surface Response Models from the subsets, and storing the Surface Response Models in memory; generating simulation data based on the Surface Response Models for data not present in the results of the Design of Experiments stored in the database and storing the simulation data in the database; filtering the results of the Design of Experiments to identify key variables; selecting, via a graphical user interface on a user display, a value for at least one of the key variables; and generating and displaying on the user display an interim output based on the selected values for the at least one of the key variables, the interim output determined based on the real data and the simulation data stored in the database.

The method as disclosed herein further comprising the step of verifying the interim output by performing a simulation using the simulation engine running on a processor based on the selected values and comparing the simulation output with the interim output.

The method disclosed herein further comprising, after the filtering step, the step of aggregating selected key variables to provide at least one aggregate function that controls values for each of the selected key variables, and wherein the step of selecting further comprises selecting, via the graphical user interface on the user display, a value for the at least one aggregate function.

The method disclosed herein wherein the step of selecting further requires that a ranking be selected for the at least one of the key variables and wherein the step of generating and displaying generates results based on the selected values and the selected rankings.

The method disclosed herein wherein the step of selecting further requires that a value be selected for all of the key variables.

The method disclosed herein wherein the step of selecting further requires that a ranking be selected for all of the key variables.

According to another aspect of the present disclosure there is provided a non-transitory computer readable storage medium storing computer usable program code for visualizing and optimizing the operation of a system of systems, comprising: program code for conducting a Design of Experiments for a particular system of systems architecture using a simulation engine running on a processor and based upon a predefined set of inputs; program code for storing the results of the Design of Experiments in a database in a memory as real data; program code for partitioning the results of the Design of Experiments into subsets, automating the construction of Surface Response Models from the subsets, and storing the Surface Response Models in memory; program code for generating simulation data based on the Surface Response Models for data not present in the results of the Design of Experiments stored in the database and storing the simulation data in the database; program code for filtering the results of the Design of Experiments to identify key variables; program code for selecting, via a graphical user interface on a user display, a value for at least one of the key variables; and program code for generating and displaying on the user display an interim output based on the selected values for the at least one of the key variables, the interim output determined based on the real data and the simulation data stored in the database.

The non-transitory computer readable storage medium disclosed herein further comprising program code for verifying the interim output by performing a simulation using the simulation engine running on a processor based on the selected values and comparing the simulation output with the interim output.

The non-transitory computer readable storage medium disclosed herein further comprising program code for aggregating, after filtering, selected key variables to provide at least one aggregate function that controls values for each of the selected key variables, and wherein program code for selecting further comprises program code for selecting, via the graphical user interface on the user display, a value for the at least one aggregate function.

The non-transitory computer readable storage medium disclosed herein wherein program code for selecting further requires that a ranking be selected for the at least one of the key variables and wherein the step of generating and displaying generates results based on the selected values and the selected rankings.

The non-transitory computer readable storage medium disclosed herein wherein program code for selecting further requires that a value be selected for all of the key variables.

The non-transitory computer readable storage medium disclosed herein wherein program code for selecting further requires that a ranking be selected for all of the key variables.

According to another aspect of the present disclosure there is provided a computer system including a user interface display device, at least one processor, and memory for storing program code executable on said at least one processor, said memory having executable program code stored thereon that, when executed, causes said computer system to perform a visualization and optimization of the operation of a system of systems, said program code comprising: program code for conducting a Design of Experiments for a particular system of systems architecture using a simulation engine running on a processor and based upon a predefined set of inputs; program code for storing the results of the Design of Experiments in a database in a memory as real data; program code for partitioning the results of the Design of Experiments into subsets, automating the construction of Surface Response Models from the subsets, and storing the Surface Response Models in memory; program code for generating simulation data based on the Surface Response Models for data not present in the results of the Design of Experiments stored in the database and storing the simulation data in the database; program code for filtering the results of the Design of Experiments to identify key variables; program code for selecting, via a graphical user interface on a user display, a value for at least one of the key variables; and program code for generating and displaying on the user display an interim output based on the selected values for the at least one of the key variables, the interim output determined based on the real data and the simulation data stored in the database.

The system disclosed herein further comprising program code for verifying the interim output by performing a simulation using the simulation engine running on a processor based on the selected values and comparing the simulation output with the interim output.

The system disclosed herein further comprising program code for aggregating, after filtering, selected key variables to provide at least one aggregate function that controls values for each of the selected key variables, and wherein program code for selecting further comprises program code for selecting, via the graphical user interface on the user display, a value for the at least one aggregate function.

The system disclosed herein wherein program code for selecting further requires that a ranking be selected for the at least one of the key variables and wherein the step of generating and displaying generates results based on the selected values and the selected rankings.

The system disclosed herein wherein program code for selecting further requires that a value be selected for all of the key variables.

The system disclosed herein wherein program code for selecting further requires that a ranking be selected for all of the key variables.

## Claims

1. A computer-implemented method for visualizing and optimizing the operation of a system of systems, comprising the steps of:
conducting a Design of Experiments for a particular system of systems architecture using a simulation engine running on a processor and based upon a predefined set of inputs;
storing the results of the Design of Experiments in a database in a memory as real data;
partitioning the results of the Design of Experiments into subsets, automating the construction of Surface Response Models from the subsets, and storing the Surface Response Models in memory;
generating simulation data based on the Surface Response Models for data not present in the results of the Design of Experiments stored in the database and storing the simulation data in the database;
filtering the results of the Design of Experiments to identify key variables;
selecting, via a graphical user interface on a user display, a value for at least one of the key variables; and
generating and displaying on the user display an interim output based on the selected values for the at least one of the key variables, the interim output determined based on the real data and the simulation data stored in the database.

2. The method of claim 1, further comprising the step of verifying the interim output by performing a simulation using the simulation engine running on a processor based on the selected values and comparing the simulation output with the interim output.

3. The method of any preceding claim, further comprising, after the filtering step, the step of aggregating selected key variables to provide at least one aggregate function that controls values for each of the selected key variables, and wherein the step of selecting further comprises selecting, via the graphical user interface on the user display, a value for the at least one aggregate function.

4. The method of any preceding claim, wherein the step of selecting further requires that a ranking be selected for the at least one of the key variables and wherein the step of generating and displaying generates results based on the selected values and the selected rankings.

5. The method of claim 4, wherein the step of selecting further requires that a value be selected for all of the key variables.

6. The method of claim 4, wherein the step of selecting further requires that a ranking be selected for all of the key variables.

7. A non-transitory computer readable storage medium storing computer usable program code for visualizing and optimizing the operation of a system of systems, comprising:
program code for conducting a Design of Experiments for a particular system of systems architecture using a simulation engine running on a processor and based upon a predefined set of inputs;
program code for storing the results of the Design of Experiments in a database in a memory as real data;
program code for partitioning the results of the Design of Experiments into subsets, automating the construction of Surface Response Models from the subsets, and storing the Surface Response Models in memory;
program code for generating simulation data based on the Surface Response Models for data not present in the results of the Design of Experiments stored in the database and storing the simulation data in the database;
program code for filtering the results of the Design of Experiments to identify key variables;
program code for selecting, via a graphical user interface on a user display, a value for at least one of the key variables; and
program code for generating and displaying on the user display an interim output based on the selected values for the at least one of the key variables, the interim output determined based on the real data and the simulation data stored in the database.

8. The non-transitory computer readable storage medium of claim 7, further comprising program code for verifying the interim output by performing a simulation using the simulation engine running on a processor based on the selected values and comparing the simulation output with the interim output.

9. The non-transitory computer readable storage medium of claim 7 or claim 8, further comprising program code for aggregating, after filtering, selected key variables to provide at least one aggregate function that controls values for each of the selected key variables, and wherein program code for selecting further comprises program code for selecting, via the graphical user interface on the user display, a value for the at least one aggregate function.

10. The non-transitory computer readable storage medium of any of claims 7 to 9, wherein program code for selecting further requires that a ranking be selected for the at least one of the key variables and wherein the step of generating and displaying generates results based on the selected values and the selected rankings.

11. The non-transitory computer readable storage medium of claim 10, wherein program code for selecting further requires that a value be selected for all of the key variables.

12. The non-transitory computer readable storage medium of claim 10, wherein program code for selecting further requires that a ranking be selected for all of the key variables.

13. A computer system including a user interface display device, at least one processor, and memory for storing program code executable on said at least one processor, said memory having executable program code stored thereon that, when executed, causes said computer system to perform a visualization and optimization of the operation of a system of systems, said program code comprising:
program code for conducting a Design of Experiments for a particular system of systems architecture using a simulation engine running on a processor and based upon a predefined set of inputs;
program code for storing the results of the Design of Experiments in a database in a memory as real data;
program code for partitioning the results of the Design of Experiments into subsets, automating the construction of Surface Response Models from the subsets, and storing the Surface Response Models in memory;
program code for generating simulation data based on the Surface Response Models for data not present in the results of the Design of Experiments stored in the database and storing the simulation data in the database;
program code for filtering the results of the Design of Experiments to identify key variables; program code for selecting, via a graphical user interface on a user display, a value for at least one of the key variables; and
program code for generating and displaying on the user display an interim output based on the selected values for the at least one of the key variables, the interim output determined based on the real data and the simulation data stored in the database.

14. The system of claim 13, further comprising program code for verifying the interim output by performing a simulation using the simulation engine running on a processor based on the selected values and comparing the simulation output with the interim output.

15. The system of claim 13 or claim 14, further comprising program code for aggregating, after filtering, selected key variables to provide at least one aggregate function that controls values for each of the selected key variables, and wherein program code for selecting further comprises program code for selecting, via the graphical user interface on the user display, a value for the at least one aggregate function.
